# EUROPEAN PATENT APPLICATION

(11) **EP 4 845 028 A1**
(43) Date of publication of application: **25.11.2026**
(21) Application number: 26173777.9
(22) Date of filing: 21.04.2026
(51) Int. Cl.: H03F 3/45, H03F 3/193, H03F 3/195

(54) **RECEIVER CIRCUIT WITH GLITCH-RESISTANT STARTUP**

(30) Priority: 20.05.2025 US 202519213058
(71) Applicant: STMicroelectronics International N.V., 1228 Plan-les-Ouates, Geneva (CH)
(72) Inventor: DEBNATH, Chandrajit, 560103 Bengaluru (IN); PAUL, Rik, 700002 Kolkata, West Bengal (IN)
(74) Representative: Buzzi, Notaro & Antonielli d'Oulx S.p.A.

(57) **Abstract**

According to an embodiment, a radio frequency receiver system includes a transimpedance amplifier (TIA) circuit with improved startup capabilities. The TIA circuit includes a first amplifier and a second amplifier arranged in a bi-quad loop configuration, with startup resistors that can be selectively coupled to virtual ground nodes through switches. A comparator monitors the output common-mode voltage and controls the switches based on comparison with two distinct threshold values, creating a hysteresis effect. When the output common-mode voltage is below a first threshold, the startup resistors are coupled to drive the virtual ground nodes toward a common-mode voltage, facilitating proper circuit initialization. Once the output common-mode voltage exceeds the first threshold, the startup resistors are decoupled, eliminating their noise contribution during normal operation. If the output common-mode voltage subsequently falls below a second threshold, the startup resistors are recoupled to prevent the circuit from entering an undesired stable state.

## Description

### TECHNICAL FIELD

The present disclosure generally relates to electronic systems. and, in particular embodiments, to a receiver circuit with glitch-resistant startup.

### BACKGROUND

Radio frequency (RF) receiver systems are widely employed in modern communication and sensing applications. These systems typically include mixers, amplifiers, and filters to process incoming RF signals. In radar applications like automotive radar systems operating at frequencies around 77 GHz, the receiver chain is designed to be high-performance with minimal noise to ensure accurate detection and measurement capabilities.

In RF receiver systems, trans-impedance amplifiers (TIAs) can be employed to convert current signals from mixers into voltage signals for subsequent processing. These amplifiers typically operate in differential configurations to improve common-mode rejection and reduce noise. The design of TIAs involves careful consideration of noise performance, bandwidth, stability, and power consumption to meet the demanding requirements of modern RF applications.

In RF receiver systems, the signal path typically begins with an RF input that feeds into a mixer. The mixer, driven by a local oscillator (LO), down converts the highfrequency RF signal to a lower frequency that subsequent stages can more easily process. The mixer's output is fed to a TIA, which converts the current signal to a voltage signal while providing gain and filtering.

High-performance RF receiver systems often employ multiple amplification stages with specific filtering characteristics. A common architecture includes filtering of low frequency high power blockers and allowing high frequency input signals to pass by implementing a high pass filter. This type of response can be achieved in different ways, such as through a high-pass filter operational amplifier in the main path and a low-pass operational amplifier LPF OPAMP in the feedback path of the high-pass filter operational amplifier. This configuration helps reject unwanted signals while amplifying the desired signal components. The coupling between these stages may involve resistors and capacitors that define the frequency response of the overall system.

The receiver analog front end in automotive radar applications requires low noise performance to detect weak reflected signals. The noise figure of the receiver chain directly impacts the radar's ability to detect distant objects or objects with small radar cross-sections.

### SUMMARY

Technical advantages are generally achieved by embodiments of this disclosure, which describe a receiver circuit with glitch-resistant startup.

A first aspect relates to a radio frequency receiver system, comprising a transimpedance amplifier (TIA) circuit including a first amplifier and a second amplifier arranged in a bi-quad loop configuration; startup resistors selectively coupled to virtual ground nodes of the TIA circuit through switches; and a hysteresis comparator circuit configured to: compare an output common-mode voltage of the TIA circuit with a first threshold and a second threshold, wherein the first threshold is greater than the second threshold, generate an enable signal to close the switches in response to the output common-mode voltage being below the second threshold, and generate the enable signal to open the switches in response to the output common-mode voltage being above the first threshold.

A second aspect relates to a method for operating a transimpedance amplifier (TIA) circuit, the method comprising initializing the TIA circuit, wherein an output common-mode voltage of the TIA circuit is initially at a low level; comparing the output common-mode voltage with a first threshold; coupling startup resistors to virtual ground nodes of the TIA circuit in response to the output common-mode voltage being below the first threshold; monitoring the output common-mode voltage as it rises during startup of the TIA circuit; decoupling the startup resistors from the virtual ground nodes in response to the output common-mode voltage exceeding the first threshold; comparing the output common-mode voltage with a second threshold during normal operation of the TIA circuit, wherein the second threshold is lower than the first threshold; and recoupling the startup resistors to the virtual ground nodes in response to the output common-mode voltage falling below the second threshold.

A third aspect relates to a first amplifier having differential inputs and differential outputs; a second amplifier having differential inputs and differential outputs; high-pass feedback resistors coupled between the differential outputs and the differential inputs of the first amplifier; low-pass feedback resistors coupled between the differential inputs of the first amplifier and the differential outputs of the second amplifier; coupling or integrating resistors coupled between the differential outputs of the first amplifier and the differential inputs of the second amplifier; coupling or integrating capacitors coupled between the differential inputs and the differential outputs of the second amplifier; first startup resistors selectively coupled to the differential inputs of the first amplifier through first switches; second startup resistors selectively coupled to the differential inputs of the second amplifier through second switches; and a control circuit configured to control the first switches and the second switches based on an output common-mode voltage of the circuit.

Embodiments can be implemented in hardware, software, or any combination thereof.

### BRIEF DESCRIPTION OF THE DRAWINGS

For a more complete understanding of the present disclosure and the advantages thereof, reference is now made to the following descriptions taken in conjunction with the accompanying drawings, in which:
Figure 1 is a diagram exemplary of a transimpedance amplifier (TIA) circuit;
Figure 2 is a diagram of an exemplary operational amplifier with an n-channel metal-oxide-semiconductor (NMOS) input stage;
Figure 3 is a diagram of an exemplary operational amplifier with a p-channel metal-oxide-semiconductor (PMOS) input stage;
Figure 4 is a diagram of a low-noise transimpedance amplifier (TIA) circuit, a common-mode voltage generator, and a hysteresis comparator circuit;
Figure 5 is a diagram of an exemplary controller;
Figure 6 is a diagram of an exemplary method for operating the TIA circuit; and
Figure 7 is a timing diagram showing an exemplary relationship between signals during the startup process of a TIA circuit.

### DETAILED DESCRIPTION OF ILLUSTRATIVE EMBODIMENTS

This disclosure provides many applicable inventive concepts that can be embodied in a wide variety of specific contexts. The particular embodiments are merely illustrative of specific configurations and do not limit the scope of the claimed embodiments. Features from different embodiments may be combined to form further embodiments unless noted otherwise. Various embodiments are illustrated in the accompanying drawing figures, where identical components and elements are identified by the same reference number, and repetitive descriptions are omitted for brevity.

Variations or modifications described in one of the embodiments may also apply to others. Further, various changes, substitutions, and alterations can be made herein without departing from the spirit and scope of this disclosure as defined by the appended claims.

While the inventive aspects are described primarily in the context of automotive radar systems, it should also be appreciated that these inventive aspects may also apply to various radio frequency communication systems. In particular, aspects of this disclosure may similarly apply to wireless communication devices, satellite receivers, medical imaging equipment, and industrial sensing applications where low-noise amplification of radio frequency signals is beneficial.

The disclosure relates to radio frequency (RF) receiver systems with improved startup capabilities for trans-impedance amplifiers (TIAs). The receiver system includes a mixer that receives RF input signals and produces differential output current signals that feed into a TIA circuit. The TIA circuit incorporates a first amplifier with a complementary input stage coupled to a second amplifier through resistors, with the overall configuration capable of providing high-pass and low-pass filtering characteristics. The second amplifier, which is used as an integrator, is in feedback of the first amplifier, generates the desired high-pass characteristics with certain advantages, such as high blocker tolerance and signal gain.

A challenge in such systems arises from the lack of a defined common-mode voltage at the virtual ground of the TIA circuit during startup. The mixer typically injects current but does not set a fixed common-mode voltage. Thus, the virtual ground of the TIA circuit is not set by a low impedance voltage source, leading to startup issues where the amplifiers remain in an undesired stable state with all inputs and outputs at zero or supply voltage levels. This condition can prevent the proper operation of the receiver system. Thus, it is advantageous to internally force the common mode voltage of the TIA circuit.

In various embodiments, the disclosed approach addresses startup challenges through a controlled switching mechanism that temporarily connects resistive paths to the virtual ground nodes of the TIA. A comparator monitors the output common-mode voltage and activates switches that connect startup resistors when the common-mode voltage falls below a threshold. Once the common-mode voltage reaches an appropriate level, the switches disconnect the startup resistors, eliminating their noise contribution during normal operation.

The comparator can incorporate hysteresis to prevent oscillation during transitions and to provide immunity against power supply glitches. The hysteresis creates different thresholds for turning the startup resistors on and off, ensuring stable operation even when noise or voltage fluctuates. For example, the resistors are turned off when the common-mode voltage reaches a first threshold and turned on if the voltage falls below a second, lower threshold.

In some embodiments, the startup resistors can be programmable or variable to accommodate different gain settings in the receiver chain. This programmability allows the startup mechanism to be optimized for various operating conditions and gain configurations, ensuring reliable startup across different modes of operation without compromising noise performance.

The disclosed approach provides advantages in noise performance compared to conventional solutions. Unlike approaches that use complementary n-channel metal-oxide-semiconductor (NMOS) and p-channel metal-oxide-semiconductor (PMOS) input stages in successive amplifiers or permanent startup resistors, the switched startup resistors contribute only a limited amount to noise (i.e., only during the initial startup phase). During normal operation, they are removed from the circuit, preserving the TIA's low-noise characteristics. These and additional details are discussed below.

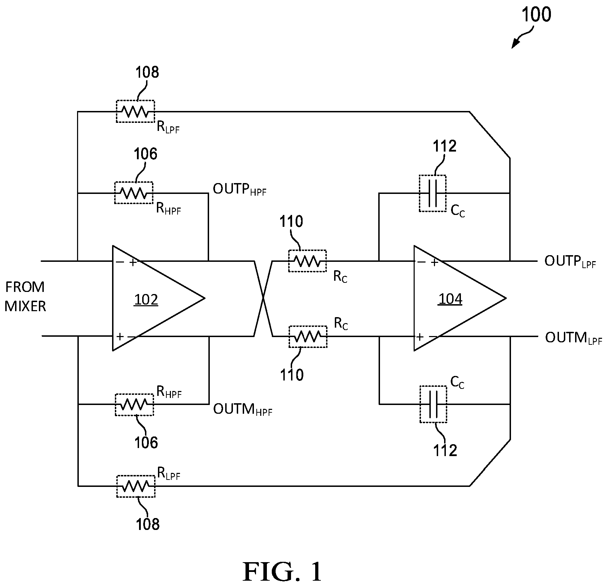

Figure 1 illustrates a schematic diagram of an example transimpedance amplifier (TIA) circuit 100. The TIA circuit 100 converts current signals from a mixer to voltage signals for subsequent processing in a radio frequency (RF) receiver system.

The TIA circuit 100 comprises a first amplifier 102 and a second amplifier 104 arranged in a bi-quad loop configuration. The input to the first amplifier 102 comes from a mixer, which provides differential current signals that need to be converted to voltage signals. The first amplifier 102 includes high-pass feedback resistors (R_{HPF}) 106 coupled between its differential outputs OUTP_{HPF} and OUTM_{HPF} and its differential inputs. Additionally, low-pass feedback resistors (R_{LPF}) 108 are coupled between the inputs of the first amplifier 102 and the outputs OUTP_{LPF} and OUTM_{LPF} of the second amplifier 104. The outputs (OUTP_{LPF} and OUTM_{LPF}) of the second amplifier 104 provide the differential output signals of the TIA circuit 100 as its main output.

The first amplifier 102 and the second amplifier 104 are coupled through the integrator resistor (R_{C}) 110, which couple the outputs of the first amplifier 102 to the inputs of the second amplifier 104. This coupling arrangement creates a signal path that allows the bi-quad loop to function while maintaining appropriate impedance levels between the stages.

The second amplifier 104 includes integrator capacitors (C_{C}) 112 coupled between its inputs and outputs. In conjunction with the coupling resistors (R_{C}) 110, the coupling capacitors (C_{C}) 112 form a low-pass filter characteristic for the second amplifier stage.

The overall architecture of the TIA circuit 100 creates a high pass response in ideal scenario but a bandpass response in reality due to op-amp poles, with the first amplifier 102 and its associated components forming a high-pass filter section due to usage of the second amplifier 104 and its components (which forms a low-pass filter section) in its feedback. This characteristic allows the TIA circuit 100 to amplify signals within the desired frequency band while attenuating unwanted signals outside this band.

The bi-quad loop configuration provides several advantages, including improved stability, better control of the frequency response, enhanced noise performance, high blocker tolerance, and high chain gain. The differential architecture throughout the signal path helps reject common-mode noise and interference, which is particularly important in sensitive RF receiver applications.

At the inputs of the first amplifier 102, virtual ground nodes are formed that serve as the interface to the mixer. These virtual ground nodes maintain a relatively constant voltage while allowing current signals from the mixer to be converted to voltage signals. However, the proper biasing of these virtual ground nodes during startup is advantageous and can present challenges that need to be addressed to ensure the reliable operation of the TIA circuit 100.

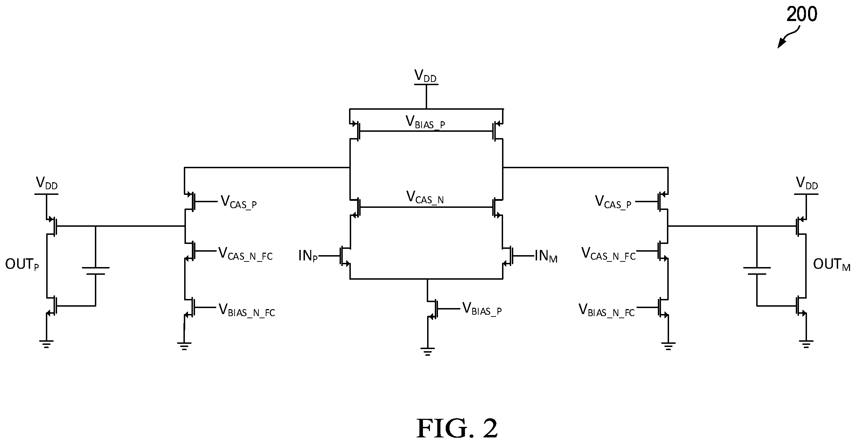

Figure 2 illustrates a schematic diagram of an operational amplifier 200 with an n-channel metal-oxide-semiconductor (NMOS) input stage, according to an embodiment of the disclosure. This circuit represents a possible implementation of the first amplifier 102 shown in Figure 1.

The operational amplifier 200 includes differential input terminals (IN_{P} and IN_{M}) that receive the input signals. The input stage comprises NMOS transistors coupled to the input terminals (IN_{P} and IN_{M}). The operational amplifier 200 is powered by a supply voltage (V_{DD}).

The operational amplifier 200 includes a positive bias voltage (V_{BIAS_P}), a positive cascode voltage (V_{CAS_P}), a negative cascode voltage (V_{CAS_N}), a negative folded cascode bias voltage (V_{BIAS_N_FC}), and a negative folded cascode voltage (V_{CAS_N_FC}). These voltages control the operating points of various transistors in the circuit.

The output stage includes transistors coupled to a positive output terminal (OUT_{P}) and a negative output terminal (OUT_{M}), which provide the differential output signals. This stage incorporates a DC level shifter for class AB operation generation. The implementation shown can utilize Monticelli biasing, an approach for DC level shifting in operational amplifier output stages to utilize class AB operation.

A characteristic of this NMOS input stage amplifier is its bistable nature. When both differential input terminals (IN_{P} and IN_{M}) are at ground potential (oV), the output terminals (OUT_{P} and OUT_{M}) settle at oV. This creates a stable "0000" state (referring to IN_{P} = IN_{M} = OUT_{P} = OUT_{M} =0) that can persist indefinitely if not disturbed. The amplifier also has a normal operating condition where all nodes are at appropriate common-mode voltages (V_{CM}).

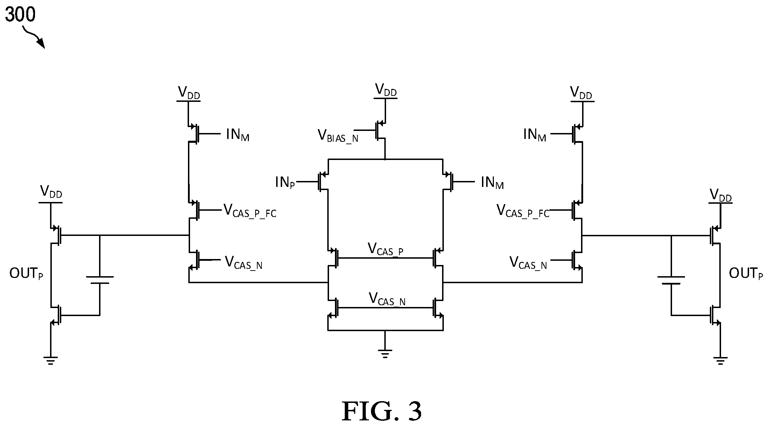

Figure 3 shows a schematic diagram of an operational amplifier 300 with a p-channel metal-oxide-semiconductor (PMOS) input stage, according to an embodiment of the disclosure. This circuit represents a possible implementation of the second amplifier 104 shown in Figure 1.

Similar to the NMOS input stage amplifier of Figure 2, this circuit includes differential input terminals (IN_{P} and IN_{M}), but uses PMOS transistors for the input stage. The circuit is also powered by the supply voltage (V_{DD}).

The operational amplifier 300 includes a negative bias voltage (V_{BIAS_N}), a positive folded cascode voltage (V_{CAS_P_FC}), a negative cascode voltage (V_{CAS_N}), and a positive cascode voltage (V_{CAS_P}). These voltages set the operating points for the transistors. The architecture also employs a folded cascode configuration for improved performance.

The output stage connects to terminals a positive output terminal (OUT_{P}) and a negative output terminal (OUT_{M}). This stage incorporates a DC level shifter for class AB operation generation. The implementation shown can utilize Monticelli biasing, an approach for DC level shifting in operational amplifier output stages to utilize class AB operation.

A characteristic of this PMOS input stage amplifier is that when both differential input terminals (IN_{P} and IN_{M}) are at the supply voltage (V_{DD}), the output terminals (OUT_{P} and OUT_{M}) settle at the supply voltage (V_{DD}). This creates a stable "1111" state (referring to IN_{P} = IN_{M} = OUT_{P} = OUT_{M} = V_{DD}) that can persist indefinitely. Like the NMOS design, this amplifier has a normal operating condition with appropriate common-mode voltages.

The complementary nature of these two amplifier designs illustrates the startup problem addressed in Figure 1. In conventional implementations, using an NMOS input stage for the first amplifier and a PMOS input stage for the second amplifier can help overcome startup issues, as the "0000" state of the NMOS amplifier would turn on the PMOS amplifier. However, PMOS input stages introduce higher noise, undesirable for low-noise applications like radar receivers.

Another conventional implementation for TIA circuit 100 (not shown) is to replace the first amplifier 102 with a low-noise operational amplifier with a complementary input stage (e.g., a tri-stable operational amplifier) with '0000' and '1111' being stable states along with normal ('V_{CM} V_{CM} V_{CM} V_{CM}'). The second amplifier 104 may be replaced with an operational amplifier having an NMOS input stage where '0000' and 'V_{CM} V_{CM} V_{CM} V_{CM}' is the stable state. At power on, both operational amplifiers can start from an OFF condition and potentially stay there and never come out. This situation does not change if the second amplifier 104 is implemented with a PMOS input stage.

Embodiments of the disclosure address this problem by using a complementary input stage for the first amplifier (which can be tri-stable with '0000', '1111', and 'V_{CM} V_{CM} V_{CM} V_{CM}' states) and providing a controlled startup mechanism through switched resistors and a hysteresis comparator. This eliminates the need for a NMOS stage followed by a noisy PMOS input stage in the signal path for auto-startup.

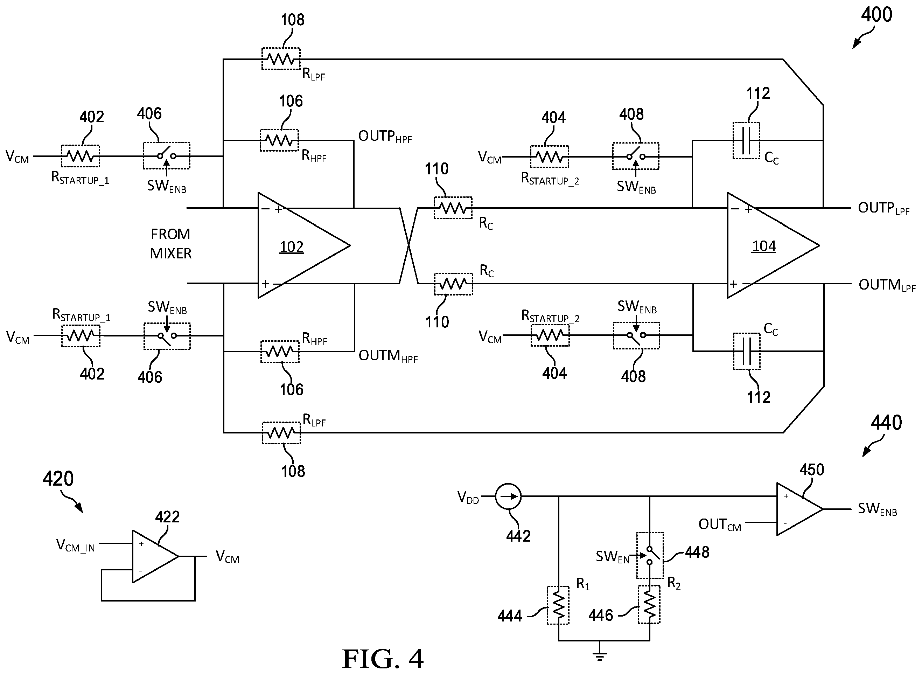

Figure 4 illustrates a schematic of a low-noise transimpedance amplifier (TIA) circuit 400, a common-mode voltage generator 420, and hysteresis comparator circuit 440, according to an embodiment of the disclosure. Similar to TIA circuit 100, TIA circuit 400 includes the first amplifier 102 and the second amplifier 104, arranged in the bi-quad loop configuration. The input to the first amplifier 102 comes from a mixer in the RF domain, which processes RF input and local oscillator signals. The mixer output is provided to the TIA circuit 400 as a current signal that is to be converted to a voltage signal.

The first amplifier 102 includes high-pass feedback resistors (R_{HPF}) 402 coupled between its outputs (OUTP_{HPF} and OUTM_{HPF}) and inputs. Additionally, low-pass feedback resistors (R_{LPF}) 404 are coupled between the inputs of the first amplifier 102 and the outputs (OUTP_{LPF} and OUTM_{LPF}) of the second amplifier 104. In embodiments, the first amplifier 102 has a complementary input stage that can include NMOS and PMOS transistors to achieve low noise performance.

The second amplifier 104 is coupled to the first amplifier 102 through coupling resistors (R_{C}) 110. The second amplifier 104 includes coupling capacitors (C_{C}) 112 coupled between its outputs (OUTP_{LPF} and OUTM_{LPF}) and inputs. This arrangement creates a low-pass filter characteristic for the second amplifier stage which is now used in the feed-back path of the high-pass filter operational amplifier to implement the high pass filter.

The system includes first startup resistors (R_{STARTUP_1}) 402 and second startup resistors (R_{STARTUP_2}) 404 that are temporarily coupled to the virtual ground nodes of the TIA circuit 100 through first switches 406 and second switches 408. The first switches 406 and the second switches 408 are coupled to the output of the hysteresis comparator circuit 440 to receive the switch enable bar signal (SW_{ENB}). In embodiments, the RF chain can incorporate adjustable gain capabilities to accommodate different operating conditions. The startup resistors can be implemented as variable resistors whose values can be dynamically adjusted through digital control, such as via a decoder circuit to support this flexibility. This adjustability allows the startup resistor value to be optimized based on the overall loop gain of the system, ensuring proper circuit startup across various gain settings.

The first startup resistors (R_{STARTUP_1}) 402 and the second startup resistors (R_{STARTUP_2}) 404 can be digitally trimmable and programmed to correlate with the system gain settings. This programmability ensures that, regardless of the configured gain of the RF chain, the startup mechanism provides adequate drive strength to properly initialize the virtual ground nodes. For example, when the system operates at higher gain settings, the startup resistors present values different from those of lower gain configurations to maintain reliable startup behavior.

The first startup resistors (R_{STARTUP_1}) 402 and the second startup resistors (R_{STARTUP_2}) 404 are configured with sufficiently low resistance values to ensure that, during initial startup, the virtual ground nodes are driven reliably to the common-mode voltage (V_{CM}) rather than remaining at zero or supply voltage levels, both of which would represent dangerous states for proper circuit operation. The ability to drive these nodes to a well-defined intermediate voltage allows for proper transitioning of the amplifiers from their off state to normal operation.

In conventional solutions, where startup resistors have been employed, they remain permanently connected to the circuit, resulting in a significant noise penalty due to their thermal noise contribution. This additional noise persists even after successful startup, creating a noisy environment that makes such implementations unsuitable for ultra-low-noise applications like radar receivers. The innovation in this disclosure lies in adding switches to selectively couple and decouple these resistors, intelligently controlling their connection timing to reduce noise while maintaining reliable startup operation.

In embodiments, the first startup resistors (R_{STARTUP_1}) 402 are equal to $\frac{1}{N} \times {R}_{LPF}$, where *N* is an integer greater than zero and *R_{LPF}* is the resistance of each of the low-pass feedback resistors (R_{LPF}) 404. The value of each of the second startup resistors (R_{STARTUP_2}) 404 can be set to be equal to $\frac{1}{M} \times {R}_{C}$*,* where *M* is an integer greater than zero and *R_{C}* is the resistance of each of the coupling resistors (R_{C}) 110. can be variable or programmable to accommodate different gain settings in the receiver chain, and their values can be trimmed and correlated with system gain. The common-mode voltage generator 420 includes an amplifier 422 that generates the common-mode voltage (V_{CM}) based on an input reference voltage (V_{CM_IN}). The input reference voltage (V_{CM_IN}) represents a desired common-mode voltage reference that, e.g., are derived from a bandgap reference circuit or other stable voltage reference source within the system. The amplifier 422 can be configured as a buffer amplifier with its positive input receiving the input reference voltage (V_{CM_IN}) and its output providing the common-mode voltage (V_{CM}).

The buffer configuration of amplifier 422 provides a low-impedance source for the common-mode voltage (V_{CM}) to drive the first startup resistors (R_{STARTUP_1}) 402 and the second startup resistors (R_{STARTUP_2}) 404. Further, amplifier 422 isolates the input reference voltage (V_{CM_IN}) from loading effects that might occur when the first startup resistors (R_{STARTUP_1}) 402 and the second startup resistors (R_{STARTUP_2}) 404 are coupled. Moreover, amplifier 422 can provide additional filtering or conditioning of the reference voltage.

The common-mode voltage (V_{CM}) generated by amplifier 422 is distributed to the first startup resistors (R_{STARTUP_1}) 402 and the second startup resistors (R_{STARTUP_2}) 404. When the first switches 406 and the second switches 408 are closed (when the switch enable bar signal (SW_{ENB}) is high), the common-mode voltage (V_{CM}) is applied through the startup resistors to the virtual ground nodes of the TIA circuit 100, establishing a well-defined common-mode voltage at these nodes during startup.

The hysteresis comparator circuit 440 includes a voltage source (V_{DD}) 442, a first resistor (R₁) 444, a second resistor (R₂) 446, a switch 448, and a comparator 450. The comparator 450 monitors the output common-mode voltage (OUT_{CM}) at its inverting input and compares it with a reference threshold at its non-inverting input. The switch 448 creates the hysteresis effect by changing the threshold based on the comparator output.

In embodiments, the output common-mode voltage (OUT_{CM}) is measured from the differential outputs (OUTP_{LPF} and OUTM_{LPF}) of the second amplifier 104. This voltage represents the average of these two differential outputs, calculated as$\frac{{OUTP}_{LPF} + {OUTM}_{LPF}}{2}$. The switch enable bar signal (SW_{ENB}) is the complement of the switch enable signal (SW_{EN}). The switch 448 is configurable between the open and closed positions based on the switch enable signal (SW_{EN}). When the switch 448 is open, the non-inverting input of comparator 450 is equal to a first threshold, and when the switch 448 is closed, the non-inverting input of comparator 450 is equal to a second threshold, where the first threshold is greater than the second threshold.

The comparator 450 monitors the output common-mode voltage (OUT_{CM}). If the output is low (00), then the output of the comparator 450 is such that the switch enable bar signal (SW_{ENB}) closes the first switches 406 and the second switches 408 coupled to the startup resistors. This results in the virtual ground of the TIA circuit 400 being driven through a low-resistive path through the startup resistors to the common-mode voltage (V_{CM}). This applies to the startup condition where the common-mode output (OUT_{CM}) is zero.

During initial operation, the comparator 450 continuously monitors the output common-mode voltage (OUT_{CM}) by comparing it with a reference threshold applied to its non-inverting input. This threshold is dynamically adjusted to create a hysteresis effect that controls when the startup resistors are coupled to or decoupled from the circuit. The threshold begins at a higher value and is reduced once the startup resistors are decoupled, creating two distinct switching points for connecting and disconnecting the resistors.

The hysteresis mechanism operates such that the first startup resistors (R_{STARTUP_1}) 402 and the second startup resistors (R_{STARTUP_2}) 404 are decoupled when the common-mode voltage (OUT_{CM}) rises above the first threshold, but are recoupled when the common-mode voltage (OUT_{CM}) falls below the second threshold. Advantageously, the separation between the coupling and decoupling thresholds provides to filter glitches on the output common mode and prevents false switching on of the startup resistors.

For example, in a system where the desired output common-mode voltage is equal to $\frac{{V}_{DD}}{2}$ (half the supply voltage), the first threshold can be set to $\frac{{V}_{DD}}{2} - Δ V$ and the second threshold can be set to $\frac{{V}_{DD}}{2} - 2 \times Δ V$*,* where *ΔV* depends on the resistance values of the first resistor (R₁) 444 and the second resistor (R₂) 446. Assuming the voltage source (V_{DD}) 442 equals 1.6 V, the target common-mode voltage would be 800 mV (1 mV = 10⁻³ V= 1 milliVolt). By defining a delta voltage of 100 mV, the first threshold can be set to 700 mV and the second threshold can be set to 600 mV.

During startup, when the common-mode output (OUT_{CM}) is initially at zero, the switch enable bar signal (SW_{ENB}) is high, which puts the first switches 406 and the second switches 408 in the closed position, coupling the startup resistors to the virtual ground nodes. This provides a low-resistance path that drives these nodes toward the common-mode voltage (V_{CM}).

When the common-mode output (OUT_{CM}) rises and reaches the first threshold, indicating the circuit is approaching normal operation, the output of the comparator 450 changes state. This opens the first switches 406 and the second switches 408, decoupling the startup resistors from the virtual ground nodes. With the circuit now in operational state, these resistors are no longer needed, and their removal reduces noise in the system.

During the functional mode, if the common-mode output (OUT_{CM}) falls below the second threshold (e.g., 600 mV), the comparator changes state again, closing the first switches 406 and the second switches 408 and reconnecting the startup resistors. This re-establishes the low-resistance path to the common-mode voltage (V_{CM}), helping to restore proper operating conditions. Once the common-mode output (OUT_{CM}) rises above the first threshold (e.g., 700 mV), the first startup resistors (R_{STARTUP_1}) 402 and the second startup resistors (R_{STARTUP_2}) 404 are decoupled once more.

The separation between the first and second threshold creates an effective hysteresis window that prevents rapid oscillation between states. The difference between the first and second thresholds can be adjusted to account for expected glitches in the system. When the common-mode output (OUT_{CM}) experiences minor fluctuations due to common-mode noise, the hysteresis ensures that the startup resistors aren't repeatedly coupled and decoupled, which would introduce switching noise and potentially cause instability.

Accordingly, after a successful startup, the virtual ground voltage stabilizes at an appropriate level once the circuit reaches its normal operating state. Similarly, the common-mode output (OUT_{CM}) rises to a stable value above the first threshold. This keeps the comparator in a state where the switch enable bar signal (SW_{ENB}) remains low, maintaining the startup resistors in a decoupled state throughout normal operation.

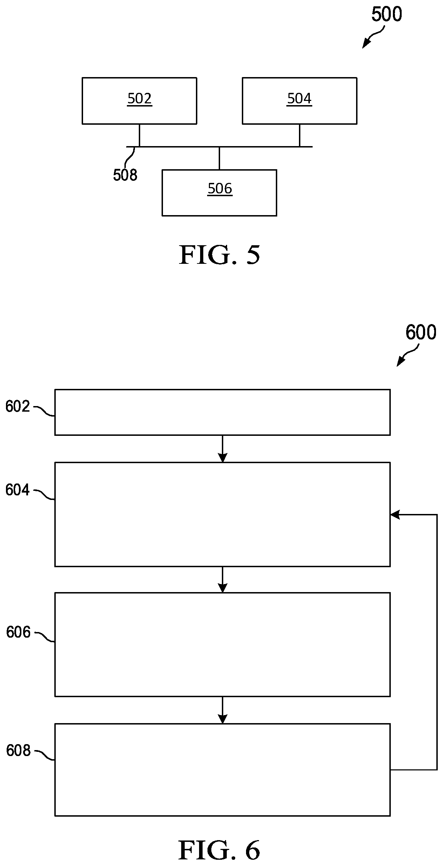

Figure 5 illustrates a block diagram of a controller 500, according to an embodiment of the disclosure. The controller 500 includes a processor 502, a memory 504, and an interface 506, which are coupled through a bus 508. The controller 500, e.g., is integrated on the same die as the TIA circuit 400 or implemented as a separate component coupled to the TIA circuit 400.

For instance, the processor 502 includes various types of processing units, such as a microprocessor, a digital signal processor (DSP), an application-specific integrated circuit (ASIC), a field-programmable gate array (FPGA), or other suitable processing elements. In some embodiments, e.g., the processor 502 includes multiple processing cores for parallel processing capabilities, enhancing the controller's performance for real-time monitoring and control tasks.

For instance, the memory 504 includes transitory memory (such as random-access memory or RAM) and non-transitory memory (such as read-only memory or ROM, flash memory, or other persistent storage). The memory 504 stores instructions that, when executed by the processor 502, cause the processor 502 to monitor the output common-mode voltage (OUTCM) of the TIA circuit 400 and compare it to a first threshold and a second threshold. Based on these comparisons, the processor 502 generates appropriate control signals to manage the startup and post-startup processes of the TIA circuit 400.

The interface 506 connects the controller 500 and the TIA circuit 400. For instance, it includes an analog-to-digital converter (ADC) that digitizes the output common-mode voltage (OUT_{CM}) from the TIA circuit 400 and provides the digitized value to the processor 502 for comparison with the stored threshold values. The interface 506, e.g., also includes digital-to-analog converters (DACs) and digital output pins for generating the switch enable bar signals (SW_{ENB}) that control the switches coupled to the startup resistors.

In embodiments where the startup resistors are implemented as variable resistors, the controller 500 can dynamically adjust their resistance values through the interface 506. This adjustment is based on various factors, such as the current gain setting of the RF chain, operating temperature, or other system parameters that might affect the startup behavior of the TIA circuit 400, for instance.

Beyond managing the startup process, the controller 500 can monitor the overall performance of the TIA circuit 400, adjusting parameters to optimize noise performance, bandwidth, or power consumption based on the current operating conditions. The controller 500 can implement calibration routines during system initialization or periodically during operation to compensate for variations due to temperature changes, aging, or other factors.

The controller 500 also interfaces with other components in the RF receiver system, coordinating the operation of the TIA circuit 400 with, e.g., mixers, filters, and other signal processing elements. It can implement power management functions, selectively enabling or disabling portions of the TIA circuit 400 when not used to conserve power, which can be particularly advantageous in battery-powered applications.

The controller 500 can collect performance metrics and diagnostic information, potentially making this data available to higher-level system components for monitoring and analysis. In more advanced implementations, e.g., the controller 500 implements adaptive algorithms that learn from the system's behavior over time, continuously optimizing the startup parameters and operating conditions to maintain optimal performance across varying environmental conditions and usage scenarios.

The bus 508 provides a communication pathway between the processor 502, memory 504, and interface 506, allowing for data transfer and control signal distribution within the controller 500. For instance, the bus architecture includes address, data, and control lines, and supports various bus protocols depending on the specific implementation requirements.

Figure 6 illustrates a flowchart diagram of a method 600 for operating a TIA circuit, according to an embodiment of the disclosure. Method 600 provides an approach to managing the startup and operational modes of the TIA circuit, ensuring proper initialization while maintaining low noise performance during normal operation. The method, e.g., includes additional or fewer steps in various embodiments, or the steps may be performed differently than illustrated.

At step 602, the system initializes the TIA circuit by applying power to the circuit components and establishing initial bias conditions. During this initialization phase, the output common-mode voltage (OUT_{CM}) is typically at or near zero, as the amplifiers have not yet reached their normal operating points. The controller 500 may set appropriate threshold values for the comparator circuit based on system requirements and operating conditions. In some embodiments, this initialization step, e.g., includes configuring the startup resistor values based on the current gain settings of the RF chain, facilitating an optimized startup behavior across different operating modes.

At step 604, the system monitors the output common-mode voltage (OUT_{CM}) and compares it with a first threshold. Since the output common-mode voltage (OUT_{CM}) is initially low during startup, it falls below the first threshold, causing the switch enable bar signal (SW_{ENB}) to be asserted. This closes the switches coupled to the startup resistors, coupling the startup resistors to the virtual ground nodes of the TIA circuit. The low-resistance path provided by the startup resistors drives the virtual ground nodes toward the common-mode voltage (V_{CM}), facilitating the transition of the amplifiers from their initial state to normal operation. In certain embodiments, the system implements a soft-start mechanism during this step, for instance, gradually increasing bias currents to prevent voltage overshoots and ensure smooth startup behavior. For instance, the method comprises providing a low resistance path to drive virtual ground nodes to the common-mode voltage in response to the output, the common-mode voltage being less than a first threshold. At step 606, as the TIA circuit begins to function, the virtual ground voltages and consequently the output common-mode voltage (OUT_{CM}) rise toward their normal operating levels. The system continues to monitor the output common-mode voltage (OUT_{CM}), and when it exceeds the first threshold, the switch enable bar signal (SW_{ENB}) is de-asserted. This opens the switches, decoupling the startup resistors from the virtual ground nodes. For instance, the method comprises decoupling the virtual ground nodes from the common-mode voltage in response to the output common-mode voltage exceeding first threshold.

Once the switch enable bar signal (SW_{ENB}) has been de-asserted, the monitoring threshold transitions from the first threshold to a second threshold that is less than the first threshold.

At step 608, the system enters normal operation mode while continuing to monitor the output common-mode voltage (OUT_{CM}) and comparing its value to the second threshold. With the TIA circuit in its normal operating state, removing the startup resistors eliminates their noise contribution, preserving the low-noise characteristics for sensitive applications like radar receivers. In some implementations, this step includes a brief delay after the output common-mode voltage (OUT_{CM}) crosses the threshold before decoupling the startup resistors, ensuring the circuit has fully stabilized, for instance. For instance, the system enters a normal operating mode while continuing to monitor the output common-mode voltage and comparing its value to a second threshold.

The system continues to monitor the output common-mode voltage (OUT_{CM}) while the TIA circuit processes signals from the mixer. During this phase, the startup resistors remain decoupled as long as the output common-mode voltage (OUT_{CM}) stays above the second threshold. In response to the output common-mode voltage (OUT_{CM}) falling below the second threshold, the system returns to step 604, where the switch enable bar signal (SW_{ENB}) is re-asserted to drive the virtual ground nodes toward the common-mode voltage (V_{CM}).

The TIA circuit operates with optimal noise performance, as the noise-contributing startup resistors are removed from the signal path. In some embodiments, a controller performs additional tasks during this step, such as periodically adjusting bias conditions to compensate for temperature variations or implementing adaptive filtering to optimize signal quality based on current operating conditions, for instance.

In response to potential disruptions that might cause the output common-mode voltage (OUT_{CM}) to drop below the second threshold-perhaps due to a significant power supply fluctuation or an external disturbance-the switch enable bar signal (SW_{ENB}) is re-asserted, reconnecting the startup resistors to the virtual ground nodes. This intervention helps prevent the TIA circuit from falling back into an undesired stable state (such as the "0000" state) by re-establishing proper biasing at the virtual ground nodes.

Once the output common-mode voltage (OUT_{CM}) rises above the first threshold again, the system returns to normal operation by decoupling the startup resistors. The hysteresis between the first and second thresholds prevents rapid oscillation between connected and disconnected states when the output common-mode voltage (OUT_{CM}) experiences minor fluctuations. In some embodiments, this step includes diagnostic functions that log the recovery events for system health monitoring or adjust the threshold separation based on the frequency of such events, for instance.

A controller coupled to TIA circuit implements additional monitoring and control functions, such as temperature compensation, power management, or performance optimization, for instance. The method 600 ensures that the TIA circuit maintains reliable operation from startup through normal functioning, with the startup resistors being dynamically managed to provide stability during initialization while preserving low-noise performance during signal processing.

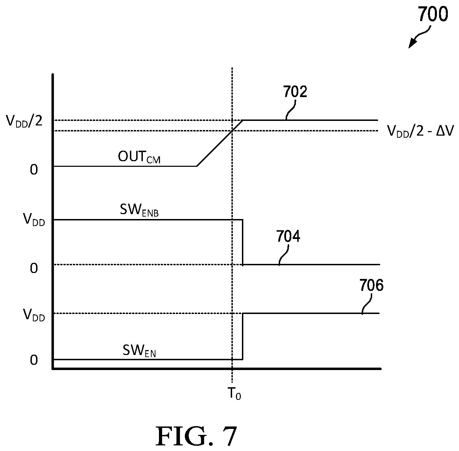

Figure 7 illustrates a timing diagram 700 showing an example relationship between signals during the startup process of a TIA circuit, according to an embodiment of the disclosure. The diagram depicts three signals: the output common-mode voltage (OUT_{CM}) 702, the switch enable bar signal (SW_{ENB}) 704, and the switch enable signal (SW_{EN}) 706.

Before time T₀, during the initial startup phase, the output common-mode voltage (OUT_{CM}) 702 begins at 0V, indicating that the TIA circuit is in its initial state. During this period, the switch enable bar signal (SW_{ENB}) 704 is asserted high, which closes the switches and couples the startup resistors to the virtual ground nodes. Correspondingly, the switch enable signal (SW_{EN}) 706 is low (at 0V).

As the TIA circuit begins to function, the output common-mode voltage (OUT_{CM}) 702 gradually rises from oV toward its normal operating level ( $\frac{{V}_{DD}}{2}$). At time T₀, the output common-mode voltage (OUT_{CM}) 702 reaches the first threshold ( $\frac{{V}_{DD}}{2} - Δ V$)*.* Slightly after time T₀, the output common-mode voltage (OUT_{CM}) 702 exceeds the first threshold, the switch enable bar signal (SW_{ENB}) 704 transitions from high to low (from V_{DD} to 0V), which opens the switches and decouples the startup resistors from the virtual ground nodes.

Simultaneously, the switch enable signal (SW_{EN}) 706 transitions from low to high (from 0V to V_{DD}), reflecting its complementary relationship with the switch enable bar signal (SW_{ENB}) 704 to operate the switch of the hysteresis comparator circuit. This transition at time marks the point where the TIA circuit has successfully started up and entered its normal operating mode, with the output common-mode voltage (OUT_{CM}) 702 continuing to rise toward $\frac{{V}_{DD}}{2}$, its target operating level.

After time T₀, the output common-mode voltage (OUT_{CM}) 702 stabilizes near $\frac{{V}_{DD}}{2}$, the startup resistors remain decoupled (as the switch enable bar signal (SW_{ENB}) 704 remains low), and the TIA circuit operates with optimal noise performance. The timing diagram effectively illustrates how the hysteresis comparator circuit monitors the output common-mode voltage and controls the switches to ensure proper startup while minimizing noise during normal operation.

Although not explicitly shown in the timing diagram 700, the hysteresis comparator circuit continues to monitor the output common-mode voltage (OUT_{CM}) 702 during normal operation. If the output common-mode voltage (OUT_{CM}) 702 were to fall below a second threshold (e.g., $\frac{{V}_{DD}}{2} - 2 \times Δ V$) due to a disturbance or power fluctuation, the hysteresis comparator would reassert the switch enable bar signal (SW_{ENB}) 704 to high, recoupling the startup resistors to the virtual ground nodes.

This protective mechanism helps prevent the TIA circuit from falling back into an undesired stable state by re-establishing the proper biasing conditions. Once the output common-mode voltage (OUT_{CM}) 702 rises above the first threshold again, the switch enable bar signal (SW_{ENB}) 704 returns to low, decoupling the startup resistors and allowing the circuit to resume normal low-noise operation. This hysteresis behavior protects against transient disturbances while maintaining optimal noise performance during steady-state operation.

A first aspect relates to a radio frequency receiver system, comprising a transimpedance amplifier (TIA) circuit including a first amplifier and a second amplifier arranged in a bi-quad loop configuration; startup resistors selectively coupled to virtual ground nodes of the TIA circuit through switches; and a hysteresis comparator circuit configured to: compare an output common-mode voltage of the TIA circuit with a first threshold and a second threshold, wherein the first threshold is greater than the second threshold, generate an enable signal to close the switches in response to the output common-mode voltage being below the second threshold, and generate the enable signal to open the switches in response to the output common-mode voltage being above the first threshold.

In a first implementation form of the radio frequency receiver system, according to the first aspect as such, the first amplifier includes a complementary input stage.

In a second implementation form of the radio frequency receiver system, according to the first aspect as such or any preceding implementation form of the first aspect, the startup resistors comprise first startup resistors coupled to inputs of the first amplifier in response to the switches being closed; and second startup resistors coupled to inputs of the second amplifier in response to the switches being closed. In a third implementation form of the radio frequency receiver system, according to the first aspect as such or any preceding implementation form of the first aspect, a resistance value of each of the first startup resistors is equal to 1/N multiplied by a resistance value of low-pass feedback resistors coupled between the inputs of the first amplifier and outputs of the second amplifier, where N is an integer greater than zero.

In a fourth implementation form of the radio frequency receiver system, according to the first aspect as such or any preceding implementation form of the first aspect, a resistance value of each of the second startup resistors is equal to 1/M multiplied by a resistance value of coupling resistors coupled between outputs of the first amplifier and inputs of the second amplifier, where M is an integer greater than zero.

In a fifth implementation form of the radio frequency receiver system, according to the first aspect as such or any preceding implementation form of the first aspect, the startup resistors are variable resistors with resistance values that are adjustable based on a gain setting of the radio frequency receiver system.

In a sixth implementation form of the radio frequency receiver system, according to the first aspect as such or any preceding implementation form of the first aspect, the hysteresis comparator circuit comprises a comparator having an inverting input coupled to receive the output common-mode voltage and a non-inverting input coupled to a reference voltage; a first resistor and a second resistor coupled in series between a non-inverting input of the comparator and ground; and a switch coupled in series with the second resistor, wherein the switch is controlled by an output of the comparator to create the hysteresis effect between the first threshold and the second threshold.

A second aspect relates to a method for operating a transimpedance amplifier (TIA) circuit, the method comprising initializing the TIA circuit, wherein an output common-mode voltage of the TIA circuit is initially at a low level; comparing the output common-mode voltage with a first threshold; coupling startup resistors to virtual ground nodes of the TIA circuit in response to the output common-mode voltage being below the first threshold; monitoring the output common-mode voltage as it rises during startup of the TIA circuit; decoupling the startup resistors from the virtual ground nodes in response to the output common-mode voltage exceeding the first threshold; comparing the output common-mode voltage with a second threshold during normal operation of the TIA circuit, wherein the second threshold is lower than the first threshold; and recoupling the startup resistors to the virtual ground nodes in response to the output common-mode voltage falling below the second threshold.

In a first implementation form of the method, according to the second aspect as such, the method further comprising generating a common-mode voltage using a buffer amplifier; and applying the common-mode voltage to the virtual ground nodes through the startup resistors in response to the startup resistors being coupled to the virtual ground nodes.

In a second implementation form of the method, according to the second aspect as such or any preceding implementation form of the second aspect, the method further comprising adjusting resistance values of the startup resistors based on a gain setting of a radio frequency chain that includes the TIA circuit.

In a third implementation form of the method, according to the second aspect as such or any preceding implementation form of the second aspect, coupling and decoupling the startup resistors comprises generating an enable signal based on the comparison of the output common-mode voltage with the first threshold and the second threshold; and controlling switches coupled between the startup resistors and the virtual ground nodes using the enable signal.

In a fourth implementation form of the method, according to the second aspect as such or any preceding implementation form of the second aspect, the method further comprising creating a hysteresis effect by using different thresholds for coupling and decoupling the startup resistors to prevent oscillation due to noise in the output common-mode voltage.

In a fifth implementation form of the method, according to the second aspect as such or any preceding implementation form of the second aspect, the startup resistors comprise: first startup resistors coupled to inputs of a first amplifier of the TIA circuit; and second startup resistors coupled to inputs of a second amplifier of the TIA circuit.

In a sixth implementation form of the method, according to the second aspect as such or any preceding implementation form of the second aspect, a resistance value of each of the first startup resistors is proportional to a resistance value of low-pass feedback resistors in the TIA circuit, and a resistance value of each of the second startup resistors is proportional to a resistance value of coupling or integration resistors in the TIA circuit.

A third aspect relates to a first amplifier having differential inputs and differential outputs; a second amplifier having differential inputs and differential outputs; high-pass feedback resistors coupled between the differential outputs and the differential inputs of the first amplifier; low-pass feedback resistors coupled between the differential inputs of the first amplifier and the differential outputs of the second amplifier; coupling or integrating resistors coupled between the differential outputs of the first amplifier and the differential inputs of the second amplifier; coupling or integrating capacitors coupled between the differential inputs and the differential outputs of the second amplifier; first startup resistors selectively coupled to the differential inputs of the first amplifier through first switches; second startup resistors selectively coupled to the differential inputs of the second amplifier through second switches; and a control circuit configured to control the first switches and the second switches based on an output common-mode voltage of the circuit.

In a first implementation form of the circuit, according to the third aspect as such, the control circuit comprises a comparator configured to compare the output common-mode voltage with a reference threshold; and a hysteresis circuit coupled to the comparator and configured to create different thresholds for closing and opening the first switches and the second switches.

In a second implementation form of the circuit, according to the third aspect as such or any preceding implementation form of the third aspect, the first amplifier comprises a complementary input stage.

In a third implementation form of the circuit, according to the third aspect as such or any preceding implementation form of the third aspect, the first startup resistors and the second startup resistors are variable resistors with resistance values that are programmable through a digital interface.

In a fourth implementation form of the circuit, according to the third aspect as such or any preceding implementation form of the third aspect, the circuit further comprising a common-mode voltage generator configured to generate a common-mode voltage that is applied to the differential inputs of the first amplifier and the differential inputs of the second amplifier through the first startup resistors and the second startup resistors, respectively, in response to the first switches and the second switches being closed.

In a fifth implementation form of the circuit, according to the third aspect as such or any preceding implementation form of the third aspect, a resistance value of each of the first startup resistors is equal to 1/N multiplied by a resistance value of each of the low-pass feedback resistors, where N is an integer greater than zero, and a resistance value of each of the second startup resistors is equal to 1/M multiplied by a resistance value of each of the coupling resistors, where M is an integer greater than zero.

Although the description has been described in detail, it should be understood that various changes, substitutions, and alterations may be made without departing from the spirit and scope of this disclosure as defined by the appended claims. The same elements are designated with the same reference numbers in the various figures. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, may perform substantially the same function or achieve substantially the same result as the corresponding embodiments described herein. Accordingly, the appended claims are intended to include within their scope such processes, machines, manufacture, compositions of matter, means, methods, or steps.

The specification and drawings are, accordingly, to be regarded simply as an illustration of the disclosure as defined by the appended claims, and are contemplated to cover any and all modifications, variations, combinations, or equivalents that fall within the scope of the present disclosure.

## Claims

1. A radio frequency receiver system, comprising:
a transimpedance amplifier, TIA circuit (100; 400) including a first amplifier (102) and a second amplifier (104) arranged in a bi-quad loop configuration;
startup resistors (402, 404) selectively coupled to virtual ground nodes of the TIA circuit (400) through switches (406, 408); and
a hysteresis comparator circuit (440) configured to:
compare an output common-mode voltage of the TIA circuit (100; 400) with a first threshold and a second threshold, wherein the first threshold is greater than the second threshold,
generate an enable signal to close the switches (406, 408) in response to the output common-mode voltage being below the second threshold, and
generate the enable signal to open the switches (406, 408) in response to the output common-mode voltage being above the first threshold.

2. The radio frequency receiver system of claim 1, wherein the first amplifier (102) includes a complementary input stage, or wherein the startup resistors (402, 404) are variable resistors with resistance values that are adjustable based on a gain setting of the radio frequency receiver system.

3. The radio frequency receiver system of claim 1, wherein the startup resistors (402, 404) comprise:
first startup resistors (402) coupled to inputs of the first amplifier (102) in response to the switches (406) being closed; and
second startup resistors (404) coupled to inputs of the second amplifier (104) in response to the switches (408) being closed.

4. The radio frequency receiver system of claim 3, wherein:
- a resistance value of each of the first startup resistors (402) is equal to 1/N multiplied by a resistance value of low-pass feedback resistors coupled between the inputs of the first amplifier (102) and outputs of the second amplifier (104), where N is an integer greater than zero, and/or
- a resistance value of each of the second startup resistors (404) is equal to 1/M multiplied by a resistance value of coupling resistors coupled between outputs of the first amplifier (102) and inputs of the second amplifier (104), where M is an integer greater than zero.

5. The radio frequency receiver system of claim 1, wherein the hysteresis comparator circuit (440) comprises:
a comparator (450) having an inverting input coupled to receive the output common-mode voltage and a non-inverting input coupled to a reference voltage;
a first resistor (444) and a second resistor (446) coupled in series between a non-inverting input of the comparator (450) and ground; and
a switch (448) coupled in series with the second resistor (446), wherein the switch (448) is controlled by an output of the comparator (450) to create the hysteresis effect between the first threshold and the second threshold.

6. A method for operating a transimpedance amplifier (TIA) circuit (400), the method comprising:
initializing the TIA circuit (400), wherein an output common-mode voltage of the TIA circuit (400) is initially at a low level;
comparing the output common-mode voltage with a first threshold;
coupling startup resistors (402, 404) to virtual ground nodes of the TIA circuit (400) in response to the output common-mode voltage being below the first threshold;
monitoring the output common-mode voltage as it rises during startup of the TIA circuit (400);
decoupling the startup resistors (402, 404) from the virtual ground nodes in response to the output common-mode voltage exceeding the first threshold;
comparing the output common-mode voltage with a second threshold during normal operation of the TIA circuit (400), wherein the second threshold is lower than the first threshold; and
recoupling the startup resistors (402, 404) to the virtual ground nodes in response to the output common-mode voltage falling below the second threshold.

7. The method of claim 6, further comprising:
generating a common-mode voltage using a buffer amplifier (422); and
applying the common-mode voltage to the virtual ground nodes through the startup resistors (402, 404) in response to the startup resistors (402, 404) being coupled to the virtual ground nodes.

8. The method of claim 6, further comprising adjusting resistance values of the startup resistors (402, 404) based on a gain setting of a radio frequency chain that includes the TIA circuit (400).

9. The method of claim 6, wherein coupling and decoupling the startup resistors (402, 404) comprises:
generating an enable signal based on the comparison of the output common-mode voltage with the first threshold and the second threshold; and
controlling switches (406, 408) coupled between the startup resistors (402, 404) and the virtual ground nodes using the enable signal.

10. The method of claim 6, further comprising creating a hysteresis effect by using different thresholds for coupling and decoupling the startup resistors (402, 404) to prevent oscillation due to noise in the output common-mode voltage.

11. The method of claim 6, wherein the startup resistors (402, 404) comprise:
first startup resistors (402) coupled to inputs of a first amplifier (102) of the TIA circuit (400); and
second startup resistors (404) coupled to inputs of a second amplifier (104) of the TIA circuit (400), preferably wherein a resistance value of each of the first startup resistors (402) is proportional to a resistance value of low-pass feedback resistors in the TIA circuit (400), and wherein a resistance value of each of the second startup resistors (404) is proportional to a resistance value of coupling or integration resistors in the TIA circuit (400).

12. A circuit (100; 400), comprising:
a first amplifier (102) having differential inputs and differential outputs;
a second amplifier (104) having differential inputs and differential outputs;
high-pass feedback resistors (106) coupled between the differential outputs and the differential inputs of the first amplifier (102);
low-pass feedback resistors (108) coupled between the differential inputs of the first amplifier (102) and the differential outputs of the second amplifier (104);
coupling or integrating resistors (110) coupled between the differential outputs of the first amplifier (102) and the differential inputs of the second amplifier (104);
coupling or integrating capacitors (112) coupled between the differential inputs and the differential outputs of the second amplifier (104);
first startup resistors (402) selectively coupled to the differential inputs of the first amplifier (102) through first switches (406);
second startup resistors (404) selectively coupled to the differential inputs of the second amplifier (104) through second switches (408); and
a control circuit configured to control the first switches (406) and the second switches (408) based on an output common-mode voltage of the circuit.

13. The circuit of claim 12, wherein the control circuit comprises:
a comparator (450) configured to compare the output common-mode voltage with a reference threshold; and
a hysteresis circuit coupled to the comparator (450) and configured to create different thresholds for closing and opening the first switches (406) and the second switches (408).

14. The circuit of claim 15, wherein the first amplifier (102) comprises a complementary input stage and/or, wherein the first startup resistors (402) and the second startup resistors (404) are variable resistors with resistance values that are programmable through a digital interface (506).

15. The circuit of claim 14, further comprising a common-mode voltage generator (420) configured to generate a common-mode voltage that is applied to the differential inputs of the first amplifier (102) and the differential inputs of the second amplifier (104) through the first startup resistors (402) and the second startup resistors (404), respectively, in response to the first switches (406) and the second switches (408) being closed, preferably wherein a resistance value of each of the first startup resistors (402) is equal to 1/N multiplied by a resistance value of each of the low-pass feedback resistors, where N is an integer greater than zero, and wherein a resistance value of each of the second startup resistors (404) is equal to 1/M multiplied by a resistance value of each of the coupling resistors, where M is an integer greater than zero.
